# DEMANDE DE BREVET EUROPEEN

(11) **EP 4 750 268 A1**
(43) Date de publication de la demande: **27.05.2026**
(21) Numéro de dépôt: 25217905.6
(22) Date de dépôt: 24.11.2025
(51) Int. Cl.: H10F 19/80, H10F 19/90, H10F 77/20

(54) **PROCÉDÉ D'INTERCONNEXION DE CELLULES PHOTOVOLTAÏQUES PAR CONTACT ENTRE DEUX ASSEMBLAGES**

(30) Priorité: 25.11.2024 FR 2412943
(71) Demandeur: Commissariat à l'Energie Atomique et aux Energies Alternatives, 75015 Paris (FR)
(72) Inventeur: MONNA, RÉMI, 38054 GRENOBLE CEDEX 09 (FR); HLADYS, BERTRAND, 38054 GRENOBLE CEDEX 09 (FR); VACHEZ, ALEXANDRE, 38054 GRENOBLE CEDEX 09 (FR)
(74) Mandataire: Regimbeau

(57) **Abrégé**

La présente invention concerne un procédé d'interconnexion de cellules photovoltaïques (4), chacune comportant des doigts de collecte, caractérisé en ce qu'il comporte les étapes successives suivantes : positionnement d'une pluralité de cellules photovoltaïques (4), selon des rangées transversales au contact de premiers fils métalliques (F1) d'un premier assemblage avant (A1), ou au contact de deuxièmes fils métalliques (F2) d'un deuxième assemblage arrière (A2), formant des rangées transversales de cellules photovoltaïques (4) interconnectées en série, les extrémités des premiers fils métalliques (F1) étant reliés à des premiers éléments de connectique (e1) et les extrémités des deuxièmes fils métalliques (F2) étant reliés à des deuxièmes éléments de connectique (e2) ; mise en contact du premier assemblage avant (A1) et du deuxième assemblage arrière (A2) pour la mise en connexion électrique des premiers éléments de connectique (e1) et des deuxièmes éléments de connectique (e2) formant des rangées longitudinales de cellules photovoltaïques (4) interconnectées en parallèle.

## Description

### DOMAINE TECHNIQUE DE L'INVENTION

La présente invention se rapporte au domaine général des modules photovoltaïques, qui comportent un ensemble de cellules photovoltaïques reliées entre elles électriquement, et préférentiellement des cellules photovoltaïques dites « cristallines », c'est-à-dire qui sont à base de silicium monocristallin ou multicristallin.

Plus précisément, l'invention se rapporte au domaine de l'interconnexion des cellules photovoltaïques qui permet la formation de chaînes ou séries (ou encore « strings » en anglais) de cellules photovoltaïques.

L'invention peut être mise en œuvre pour de nombreuses applications, notamment pour des bâtiments tels que des habitats ou locaux industriels (tertiaires, commerciaux, ...), par exemple pour la réalisation de leurs toitures, pour la conception de mobilier urbain, par exemple pour de l'éclairage public, la signalisation routière ou encore la recharge de voitures électriques, voire également être utilisée pour des applications nomades, en particulier pour une intégration sur des voitures, bus ou bateaux, entre autres.

L'invention concerne ainsi un procédé d'interconnexion de cellules photovoltaïques par mise en contact d'un premier assemblage avant avec un deuxième assemblage arrière, ainsi qu'un procédé de fabrication d'un module photovoltaïque associé.

### ETAT DE LA TECHNIQUE

Un module photovoltaïque est un assemblage de cellules photovoltaïques disposées côte à côte entre une première couche transparente formant une face du module photovoltaïque et une seconde couche formant une face arrière du module photovoltaïque.

La première couche formant la face avant du module photovoltaïque est avantageusement transparente pour permettre aux cellules photovoltaïques de recevoir un flux lumineux. Elle est traditionnellement réalisée en une seule plaque de verre, présentant une épaisseur typiquement comprise entre 2 mm et 4 mm, classiquement de l'ordre de 3 mm.

La deuxième couche formant la face arrière du module photovoltaïque peut quant à elle être réalisée à base de verre ou de métal, entre autres. Elle est souvent formée par une structure polymérique à base d'un polymère isolant électrique, par exemple du type polytéréphtalate d'éthylène (PET) ou polyamide (PA), pouvant être protégée par une ou des couches à base de polymères fluorés, comme le polyfluorure de vinyle (PVF) ou le polyfluorure de vinylidène (PVDF), et ayant une épaisseur de l'ordre de 400 µm.

Les cellules photovoltaïques, qui se présentent sous forme de fines plaques d'environ 180 µm d'épaisseur, peuvent être reliées électriquement entre elles (interconnectées) par des éléments de contact électrique avant et arrière, appelés conducteurs de liaison, et formés par exemple par des bandes (ou rubans) ou fils de cuivre étamé (ou gainé), notamment respectivement disposées contre les faces avant (faces se trouvant en regard de la face avant du module photovoltaïque destinée à recevoir un flux lumineux) et arrière (faces se trouvant en regard de la face arrière du module photovoltaïque) de chacune des cellules photovoltaïques.

Par ailleurs, les cellules photovoltaïques, situées entre les première et deuxième couches formant respectivement les faces avant et arrière du module photovoltaïque, peuvent être encapsulées. De façon classique, l'encapsulant choisi correspond à un polymère du type élastomère (ou caoutchouc), et peut par exemple consister en l'utilisation de deux couches (ou films) de poly(éthylène-acétate de vinyle) (EVA) entre lesquelles sont disposées les cellules photovoltaïques et les conducteurs de liaison des cellules. Chaque couche d'encapsulant peut présenter une épaisseur d'au moins 0,2 mm et un module de Young typiquement compris entre 2 et 400 MPa à température ambiante.

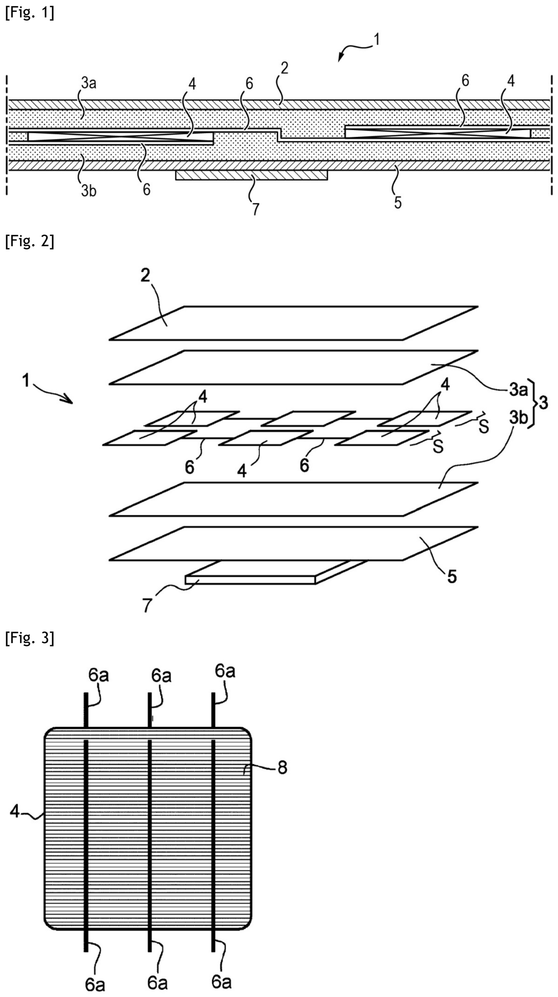

On a ainsi représenté partiellement et schématiquement, respectivement en coupe sur la figure 1 et en vue éclatée sur la figure 2, un exemple classique de module photovoltaïque 1 comportant des cellules photovoltaïques 4 cristallines.

Comme décrit précédemment, le module photovoltaïque 1 comporte une face avant 2, généralement réalisée en verre trempé transparent d'épaisseur d'environ 3 mm, et une face arrière 5, par exemple constituée par une feuille polymère, opaque ou transparente, monocouche ou multicouche, ayant un module de Young supérieur à 400 MPa à température ambiante.

Entre les faces avant 2 et arrière 5 du module photovoltaïque 1 se situent les cellules photovoltaïques 4, reliées électriquement entre elles par des conducteurs de liaison 6 et immergées entre deux couches avant 3a et arrière 3b de matériau d'encapsulation formant toutes les deux un ensemble encapsulant 3.

Par ailleurs, les figures 1 et 2 représentent également la boîte de jonction 7 du module photovoltaïque 1, destinée à recevoir le câblage nécessaire à l'exploitation du module photovoltaïque 1 et raccordant les bandes de cuivre du circuit de cellules photovoltaïques 4. Classiquement, cette boîte de jonction 7 est réalisée en plastique ou en caoutchouc, et présente une étanchéité complète. Enfin, bien que non représenté sur les figures 1 et 2, un cadre en aluminium est prévu autour de l'ensemble des couches décrites auparavant pour finaliser le module photovoltaïque 1.

Ainsi, un module photovoltaïque 1 comprend une multitude de cellules photovoltaïques 4 identiques connectées en série et/ou en parallèle afin de fournir en sortie la tension et/ou le courant requis pour alimenter des dispositifs électriques. Le format de module le plus courant emploie 60 cellules carrées, ou « pseudo-carrées », de 156 mm de côté, réparties en six chaînes ou séries S, comme visible sur la figure 2, appelées encore « strings » en anglais, de dix cellules interconnectées en série. Les six chaînes S de cellules photovoltaïques 4 sont également interconnectées en série.

Les porteurs de charge photogénérés, qui contribuent au courant électrique de la cellule photovoltaïque 4, sont collectés grâce à un réseau d'électrodes déposé sur la face avant de la cellule. Ces électrodes, appelées également doigts de collecte, sont étroites, typiquement de dimension inférieure à 45 µm. Elles sont généralement formées par sérigraphie d'une pâte contenant de l'argent. La face arrière de la cellule est généralement recouverte d'un autre réseau d'électrodes (cas des cellules bifaciales). Le courant électrique circule ensuite d'une cellule à l'autre de la chaîne S par des interconnexions.

La présente invention est concernée par l'interconnexion des cellules photovoltaïques. Les technologies d'interconnexion sont variées et généralement adaptées aux technologies de cellules solaires utilisées pour la création des modules photovoltaïques. La façon dont les cellules solaires sont connectées entre elles peut permettre d'améliorer les performances du module photovoltaïque indépendamment de celles des cellules solaires mais également de réduire les pertes dites CTM (pour « Cell-To-Module » en anglais).

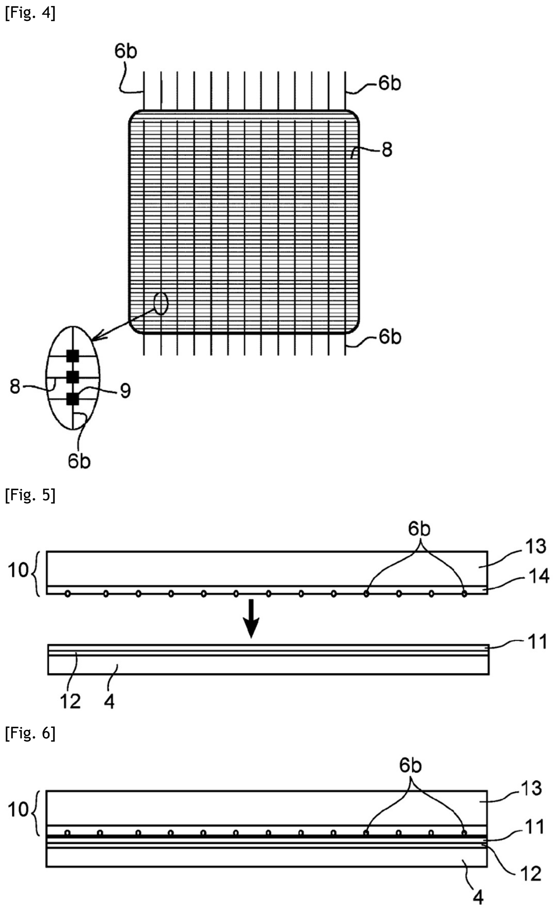

On distingue classiquement deux techniques majeures pour interconnecter les cellules photovoltaïques d'une chaîne : les interconnexions en forme de ruban et les interconnexions en forme de fil métallique. Il s'agit habituellement de fils ou de rubans de cuivre recouverts d'un revêtement fusible, par exemple à base d'étain et de plomb, ou d'étain, d'argent et de cuivre (SAC pour SnAgCu). Ces deux techniques sont respectivement représentées par les figures 3 et 4.

Sur la figure 3, les interconnexions entre les cellules 4 sont constituées de rubans 6a en cuivre recouverts d'un alliage fusible, typiquement un alliage d'étain et de plomb ou un alliage d'étain, d'argent et de cuivre. Ces rubans 6a de section rectangulaire sont soudés sur des pistes conductrices appelées « busbars » et formées, lors de l'étape de métallisation de la cellule photovoltaïque 4, en même temps que les doigts de collecte 8 par sérigraphie. Les busbars relient électriquement les doigts de collecte 8 et sont orientés perpendiculairement aux doigts de collecte 8.

Une cellule de 156,75 mm x 156,75 mm (M2) compte généralement six rubans de 0,6 mm de large, ces rubans ayant une épaisseur de l'ordre de 0,2 mm. Chaque ruban 6a connecte la face avant d'une cellule 4 à la face arrière de la cellule 4 suivante dans la chaîne (non représentée sur la figure 3). La mise en série des cellules photovoltaïques 4 au moyen des rubans 6a s'effectue de façon entièrement automatisée, dans un équipement appelé « stringer ».

Pendant longtemps, la technologie à six busbars (dite 6BB) a été prédominante sur le marché mais le développement de la technologie multifils a amené à augmenter le nombre de bus jusqu'à neuf, voire davantage, ce que l'on nomme aujourd'hui les « Multi-Busbars (MBB) ». Ces technologies MBB, en plus de leur apport en puissance sur les modules photovoltaïques, permettent une meilleure tenue des modules aux tests de vieillissement accéléré, une diminution de la quantité de pâte d'argent, et donc une réduction du coût de production.

Ces technologies MBB sont en particulier connues au travers de la technologie « MultiWire », ou multifils, développée par la société « Schmid » et décrite dans l'article « Multi-busbar solar cells and modules : high efficiencies and low silver consumption », S. Braun et al., Energy Procedia, vol. 38, pp. 334-339, 2013, qui multiplie le nombre de busbars déposés sur la cellule, passant de trois à quinze busbars, et soude à chaque busbar un fil de 200 µm de diamètre. Cette technologie est schématisée sur la figure 4. Les fils 6b sont constitués de cuivre et recouverts d'une fine couche d'un alliage à base d'étain-plomb ou d'étain-argent-cuivre dont le point de fusion est situé au-dessus de 210°C. Les busbars ont une forme discontinue. Ils se composent de plots de métallisation 9, d'environ 500 µm x 700 µm, pouvant être alignés sur les doigts de collecte 8 comme représenté ici. Les plots de métallisation 9 et les doigts de collecte 8 sont généralement réalisés par sérigraphie d'une pâte d'argent. La soudure des fils 6b sur les plots 9 a lieu immédiatement après avoir posé les fils 6b sur les plots 9, dans le même équipement, en chauffant ces éléments à une température supérieure à la température de fusion de l'alliage métallique recouvrant les fils (de l'ordre de 200°C à 240°C). Ainsi, l'alliage recouvrant les fils 6b de cuivre est fondu. Cette technologie a été largement reprise dans le monde, et permet par exemple de souder par rayons infrarouges de 12 à 15 fils de 250 µm à 350 µm de diamètre. Cette technologie peut également s'appliquer à certains types de cellules photovoltaïques, comme les cellules à hétérojonction de silicium (SHJ) qui présentent une sensibilité aux températures proches de 200°C, en réalisant la soudure dans des conditions restrictives, notamment par la sélection de certaines pâtes de métallisation optimisées vis-à-vis de la soudure et avec un pic de soudure bref, par exemple par rayonnement infrarouge, et un revêtement avec un alliage à base de bismuth, par exemple SnPbBi 42/37/21 avec une température de fusion comprise entre 118°C et 122°C.

L'interconnexion de cellules photovoltaïques peut se faire également par dépôt d'une colle polymère conductrice, appelée ECA pour « Electrically Conductive Adhesive » en anglais, directement sur les busbars ou pads des deux faces des cellules. Au sein d'un stringer, ce dépôt peut être réalisé par un procédé de dispense, par exemple par jet d'encre ou autre technologie de valve de dispense. Industriellement, le dépôt d'ECA est réalisé par sérigraphie, ce qui procure l'avantage de pouvoir réaliser des dépôts localisés sur une grande variété de cellules.

En outre, la technologie « SmartWire », encore appelée SWCT^{®}, développée par la société « Meyer Burger », connue de DE 102 39 845 C1 et également décrite dans l'article « Smart Wire Connection Technology », T. Söderström et al., Proceedings of the 28th European Photovoltaics Solar Energy Conference, pp. 495-499, 2013, consiste à déposer une nappe de 18 à 36 fils de 200 µm ou 250 µm de diamètre directement sur les doigts de collecte. Autrement dit, les cellules photovoltaïques sont dépourvues de busbars. Les fils sont tenus par un film support en polyoléfine, par exemple, qui est collé sur chaque face des cellules. Les fils ont une âme en cuivre et un revêtement extérieur formé d'un alliage à faible point de fusion (SnAgBi). Cet alliage possède une température de fusion comprise entre 120°C et 150°C, ce qui permet de réaliser la connexion électrique entre les fils et les doigts de collecte, non pas lors de l'étape d'interconnexion des cellules (par chauffage localisé vers 100°C), mais lors de l'étape de lamination des modules photovoltaïques (qui se fait à plus haute température, généralement vers 150-160°C). Cette technologie, en supprimant les sérigraphies nécessaires aux busbars, permet de réduire la consommation d'argent. L'utilisation d'un grand nombre de fils, supérieur à 18, permet de réduire les pertes résistives et optiques afin d'augmenter la performance des modules photovoltaïques.

Les figures 5 et 6 permettent d'illustrer le principe de la technologie « SmartWire ». La figure 5 illustre schématiquement, en coupe, l'application du film support 10 sur la sérigraphie 11 de la cellule photovoltaïque 4, et la figure 6 illustre schématiquement, en coupe, l'interconnexion électrique obtenue de la cellule 4 de la figure 5 après application du film support 10.

Ainsi, les fils 6b sont tenus par le film support 10 qui comprend une couche 13 en fluoropolymère, par exemple, et une couche adhésive 14 de type acrylique, élastomère (ou caoutchouc), polyvinyle éther, éthylène-acétate de vinyle (EVA) ou encore époxy, sur laquelle sont placés les fils 6b. Comme visible sur la figure 5, ce film support 10 est alors plaqué sur la sérigraphie 11 de la cellule 4, cette sérigraphie 11 comprenant les doigts de collecte 8, pour obtenir la structure de la figure 6. De plus, sur ces figures 5 et 6, on peut également voir qu'une couche anti-reflet 12 est prévue entre la cellule photovoltaïque 4 et la sérigraphie 11. Cette couche anti-reflet 12 est typiquement une couche d'oxyde d'indium-étain (ou encore ITO pour « Indium Tin Oxide » en anglais) ou encore une couche de nitrure de silicium (SiN).

Les interconnexions en forme de fil métallique permettent de réduire la longueur des doigts de collecte par rapport à la configuration à trois busbars (voir la figure 3), car le nombre de fils est plus important que le nombre de rubans. Cette augmentation du nombre d'interconnexions n'a pas nécessairement d'impact sur l'ombrage de la cellule photovoltaïque en raison de la plus petite taille des fils. Cependant, elle permet de réduire considérablement la quantité d'argent utilisée pour imprimer les doigts de collecte. En effet, les doigts de collecte étant moins longs, on peut soit réduire la largeur des doigts, soit utiliser une pâte moins riche en argent, et donc moins conductrice, pour une résistance série équivalente. En outre, grâce à leur section circulaire, les fils métalliques ont un ombrage effectif sur la cellule photovoltaïque inférieur à celui des rubans plats. Ainsi, pour un ensemble d'interconnexions ayant une même section transversale, le taux d'ombrage sur des cellules interconnectées par fils est plus faible que celui sur des cellules interconnectées par rubans.

L'interconnexion standard par rubans ou multifils présente des inconvénients. Dans ce procédé, les rubans ou fils en cuivre sont connectés sur la face avant de la première cellule et sur la face arrière de la deuxième cellule adjacente. Ce type d'interconnexion a le désavantage de créer des contraintes mécaniques au niveau des bords des cellules photovoltaïques et d'imposer une distance minimale entre les cellules. Une variante de ce procédé est le pavage ou « paving » en anglais, qui prévoit un chevauchement d'environ un millimètre des cellules supprimant l'espace entre celles-ci tout en gardant les rubans d'interconnexion. Dans ce cas, les contraintes subsistent et une partie de la cellule est ombrée, ce qui fait perdre de la surface active et donc de la puissance au module photovoltaïque.

Un autre procédé d'interconnexion dit « tuilage » ou « shingle » en anglais consiste à couper les cellules photovoltaïques en lamelles et à les interconnecter en tuilage sans l'utilisation de rubans. Plus précisément, dans ce procédé, les cellules photovoltaïques sont découpées en taille 1/6 de cellules et sont ensuite assemblées en tuilage à l'aide d'une colle conductrice. Dans ce cas, il existe également une surépaisseur au niveau de l'interconnexion qui peut induire des casses mécaniques lors de la lamination du module photovoltaïque. Compte-tenu de la longueur des lignes de métallisation des cellules, ce type de connexion augmente la résistance en série des modules. Dans le cas par exemple de cellules à hétérojonction (HJT) où les lignes de métallisation sont peu conductrices, il est nécessaire d'augmenter la quantité d'argent déposé, par exemple de l'ordre de plus de 30 % à 40 % en comparaison avec l'interconnexion par rubans ou par fils.

### EXPOSE DE L'INVENTION

L'invention a pour but de remédier au moins partiellement aux besoins mentionnés ci-dessus et aux inconvénients relatifs aux réalisations de l'art antérieur.

En particulier, elle vise à simplifier le procédé d'interconnexion de cellules photovoltaïques en évitant notamment toute contrainte sur les bords des cellules.

L'invention a ainsi pour objet, selon l'un de ses aspects, un procédé d'interconnexion de cellules photovoltaïques, les cellules photovoltaïques étant chacune recouvertes d'une grille métallisée comportant des doigts de collecte, caractérisé en ce qu'il comporte les étapes successives suivantes :
- l'étape de positionnement d'une pluralité de cellules photovoltaïques, selon des rangées transversales s'étendant selon une direction transversale, les doigts de collecte étant orientés selon une direction longitudinale perpendiculaire à la direction transversale, au contact de premiers fils métalliques, orientés selon la direction longitudinale, d'un premier assemblage avant, ou au contact de deuxièmes fils métalliques, orientés selon la direction longitudinale, d'un deuxième assemblage arrière, formant des rangées transversales de cellules photovoltaïques interconnectées en série, les extrémités des premiers fils métalliques étant reliés à des premiers éléments de connectique et les extrémités des deuxièmes fils métalliques étant reliés à des deuxièmes éléments de connectique,
- l'étape de mise en contact du premier assemblage avant et du deuxième assemblage arrière pour la mise en connexion électrique des premiers éléments de connectique et des deuxièmes éléments de connectique formant des rangées longitudinales de cellules photovoltaïques interconnectées en parallèle.

Le procédé d'interconnexion selon l'invention peut en outre comporter l'une ou plusieurs des caractéristiques suivantes prises isolément ou suivant toutes combinaisons techniques possibles.

La grille métallisée peut avantageusement comporter une sérigraphie des doigts de collecte.

Chaque cellule photovoltaïque peut avantageusement être dépourvue de piste conductrice de type busbar, ou encore appelée bus de collecte.

Par ailleurs, chaque cellule photovoltaïque peut présenter un format découpé, résultant d'un découpage en N parties, N étant un nombre entier supérieur ou égal à 2, notamment égal à 6, du format d'une cellule photovoltaïque de référence, notamment une cellule photovoltaïque de référence de type Mx ou Gx où x désigne un nombre entier supérieur ou égal à 0, notamment compris entre 0 et 12.

De plus, chaque cellule photovoltaïque peut présenter une largeur, mesurée selon la direction transversale, comprise entre 156 mm et 210 mm.

Les premiers fils métalliques et/ou les deuxièmes fils métalliques peuvent être des fils constitués d'un cœur en un unique métal, notamment du cuivre, et d'un revêtement en un alliage métallique, notamment de type SnPb, SnPbBi, SnAgBi ou SnAgCu.

En outre, l'étape de positionnement de la pluralité de cellules photovoltaïques peut comporter le positionnement des cellules photovoltaïques en juxtaposition les unes des autres, sans recouvrement entre elles, notamment avec un espacement entre deux cellules photovoltaïques adjacentes compris entre 0 et 0,5 mm.

Par ailleurs, l'invention a également pour objet, selon un autre de ses aspects, un procédé de fabrication d'un module photovoltaïque comportant :
- une première couche formant la face avant du module photovoltaïque,
- une pluralité de cellules photovoltaïques disposées côte à côte et reliées électriquement entre elles,
- un ensemble encapsulant la pluralité de cellules photovoltaïques, l'ensemble encapsulant étant formé par une couche avant de matériau d'encapsulation et une couche arrière de matériau d'encapsulation disposées de part et d'autre des cellules photovoltaïques,
- une deuxième couche formant la face arrière du module photovoltaïque, l'ensemble encapsulant et la pluralité de cellules photovoltaïques étant situés entre les première et deuxième couches, au moins l'une des première couche et deuxième couche étant transparente et destinée à recevoir un flux lumineux,
caractérisé en ce qu'il comporte l'étape d'interconnexion des cellules photovoltaïques par le biais d'un procédé d'interconnexion tel que défini précédemment.

Le procédé de fabrication peut comporter l'étape de formation d'un premier assemblage avant, comportant :
- un premier cadre avant défini par deux montants longitudinaux avant, parallèles à la direction longitudinale, et deux montants transversaux avant, parallèles à la direction transversale, perpendiculaire à la direction longitudinale,
- la première couche s'étendant entre les montants longitudinaux avant et les montants transversaux avant du premier cadre avant,
- la couche avant de matériau d'encapsulation s'étendant au contact de la première couche,
- une pluralité de premiers fils métalliques avant s'étendant transversalement entre les deux montants transversaux avant du premier cadre avant au contact de la couche avant de matériau d'encapsulation,
- une pluralité de premiers éléments de connectique disposés sur les montants longitudinaux avant, les premiers fils métalliques étant reliés aux premiers éléments de connectique.

De plus, le procédé de fabrication peut comporter l'étape de formation d'un deuxième assemblage arrière, comportant :
- un deuxième cadre arrière défini par deux montants longitudinaux arrière, parallèles à la direction longitudinale, et deux montants transversaux arrière, parallèles à la direction transversale, perpendiculaire à la direction longitudinale,
- la deuxième couche s'étendant entre les montants longitudinaux arrière et les montants transversaux arrière du deuxième cadre arrière,
- la couche arrière de matériau d'encapsulation s'étendant au contact de la deuxième couche,
- une pluralité de deuxièmes fils métalliques arrière s'étendant transversalement entre les deux montants transversaux arrière du deuxième cadre arrière au contact de la couche arrière de matériau d'encapsulation,
- une pluralité de deuxièmes éléments de connectique disposés sur les montants longitudinaux arrière, les deuxièmes fils métalliques étant reliés aux deuxièmes éléments de connectique.

Le procédé de fabrication peut comporter l'étape de positionnement d'un matériau isolant au contact des premiers éléments de connectique et/ou au contact des deuxièmes éléments de connectique.

Par ailleurs, l'étape d'interconnexion des cellules photovoltaïques peut comporter la mise en contact du premier assemblage avant et du deuxième assemblage arrière, laquelle peut être suivie par une étape d'étanchéification du pourtour du module photovoltaïque, notamment par le positionnement d'au moins un joint de scellement sur le pourtour du module photovoltaïque, notamment entre les premier cadre avant et deuxième cadre arrière, entre le premier cadre avant et la première couche et/ou entre le premier cadre arrière et la deuxième couche.

L'étape d'interconnexion des cellules photovoltaïques peut être suivie d'une étape de brasage.

De plus, le procédé de fabrication peut comporter une étape de lamination à chaud à une température supérieure ou égale à 90°C, notamment supérieure ou égale à 100°C, notamment encore supérieure ou égale à 120°C, notamment encore inférieure à 180°C, notamment encore inférieur à 170°C, notamment comprise entre 150°C et 180°C, voire encore entre 160°C et 170°C, et pendant une durée du cycle de lamination d'au moins 10 minutes, des couches constitutives du module photovoltaïque.

L'étape de brasage peut être réalisée au cours de l'étape de lamination à chaud.

En outre, les étapes du procédé d'interconnexion et/ou du procédé de fabrication peuvent être réalisées de manière automatisée, notamment par le biais de robots de manipulation.

Il convient par ailleurs de noter que le terme « transparent » signifie que le matériau de la première couche et/ou de la deuxième couche est au moins partiellement transparent à la lumière visible, laissant passer au moins environ 80 % de cette lumière.

En outre, par le terme « encapsulant », il faut comprendre que la pluralité de cellules photovoltaïques est disposée dans un volume, par exemple hermétiquement clos vis-à-vis de l'humidité, au moins en partie formé par au moins une couche composée d'un matériau polymère dit d'encapsulation. En général, on utilise au moins deux couches d'encapsulation disposées de part et d'autre des cellules photovoltaïques et réunies entre elles après assemblage, notamment par lamination, pour former l'ensemble encapsulant les cellules. Ainsi, initialement, c'est-à-dire avant toute opération d'assemblage, l'ensemble encapsulant peut être constitué par au moins deux couches de matériau d'encapsulation, dites couches de cœur, entre lesquelles la pluralité de cellules photovoltaïques est encapsulée. Toutefois, pendant l'opération d'assemblage, le ou les matériaux d'encapsulation fondent pour ne former, après l'opération d'assemblage, qu'une seule couche (ou ensemble) solidifiée dans laquelle sont noyées ou encapsulées les cellules photovoltaïques.

L'ensemble encapsulant peut notamment être réalisé à partir d'au moins un matériau polymère choisi parmi : le poly(éthylène-acétate de vinyle) (EVA), les ionomères, les polyoléfines, les acétals de vinyle, tels que les polyvinylbutyrals (PVB), les chlorures de polyvinyle (PVC), les polydiméthylsiloxanes, les polyuréthanes (PU) ou encore le polyméthacrylate de méthyle (PMMA), l'éthylène-acrylate de méthyle (EMA), le butylacrylate d'éthylène (EBA), l'éthylène-propylène (EPM/EPDM).

La première couche peut être réalisée en verre, ou encore en au moins un matériau polymère, tel que le polyméthacrylate de méthyle (PMMA), le polycarbonate (PC), des fibres de verre ou de carbone imprégnées, entre autres. La deuxième couche peut être réalisée en verre, en métal ou encore en au moins un matériau polymère tel que le polyméthacrylate de méthyle (PMMA), le polycarbonate (PC), des fibres de verre ou de carbone imprégnées, entre autres.

De plus, l'ensemble encapsulant peut préférentiellement être réalisé à partir de deux couches de poly(éthylène-acétate de vinyle) (EVA) entre lesquelles sont disposées les cellules photovoltaïques.

Les cellules photovoltaïques peuvent être choisies parmi : des cellules photovoltaïques homojonction ou hétérojonction à base de silicium monocristallin (c-Si) et/ou multi-cristallin (mc-Si), et/ou des cellules photovoltaïques comprenant au moins un matériau parmi le silicium amorphe (a-Si), le silicium microcristallin (µC-Si), le tellurure de cadmium (CdTe), le cuivre-indium séléniure (CIS) et le cuivre-indium/gallium diséléniure (CIGS), entre autres. Par ailleurs, les cellules photovoltaïques peuvent présenter une épaisseur comprise entre 1 et 300 µm.

Le module photovoltaïque peut en outre comporter une boîte de jonction, destinée à recevoir le câblage nécessaire à l'exploitation du module photovoltaïque.

Le procédé d'interconnexion et le procédé de fabrication selon l'invention peuvent comporter l'une quelconque des caractéristiques précédemment énoncées, prises isolément ou selon toutes combinaisons techniquement possibles avec d'autres caractéristiques.

### DESCRIPTION DES FIGURES

D'autres avantages, buts et caractéristiques particulières de l'invention ressortiront de la description non limitative qui suit d'au moins un mode de mise en œuvre de la présente invention, en regard des figures annexées, sur lesquelles :
- la figure 1 représente, en coupe, un exemple classique de module photovoltaïque comportant des cellules photovoltaïques cristallines,
- la figure 2 représente, en vue éclatée, le module photovoltaïque de la figure 1,
- les figures 3 et 4 représentent schématiquement deux techniques d'interconnexion de cellules photovoltaïques selon l'art antérieur,
- la figure 5 illustre schématiquement, en coupe, l'application d'une électrode sur la sérigraphie d'une cellule photovoltaïque selon le principe d'interconnexion « SmartWire »,
- la figure 6 illustre schématiquement, en coupe, l'interconnexion électrique obtenue de la cellule photovoltaïque de la figure 5 après application de l'électrode,
- la figure 7 représente schématiquement, selon une vue dans un plan formé par les directions transversale et longitudinale, la formation du premier assemblage avant selon le procédé de fabrication conforme à l'invention,
- la figure 8 représente schématiquement, selon une vue dans un plan formé par les directions transversale et longitudinale, la formation du deuxième assemblage arrière selon le procédé de fabrication conforme à l'invention,
- la figure 9 représente schématiquement la mise en place des cellules photovoltaïques sur le deuxième assemblage arrière de la figure 8 selon le procédé d'interconnexion conforme à l'invention,
- la figure 10 représente schématiquement la mise en place du premier assemblage avant de la figure 7 sur le deuxième assemblage arrière de la figure 9 selon le procédé d'interconnexion conforme à l'invention,
- la figure 11 illustre schématiquement, en coupe longitudinale, la mise en contact du premier assemblage avant de la figure 7 et du deuxième assemblage arrière de la figure 9,
- la figure 12 illustre l'assemblage final obtenu après la mise en contact de la figure 11,
- la figure 13 représente schématiquement, en coupe transversale, un exemple de module photovoltaïque obtenu après mise en contact du premier assemblage avant de la figure 7 et du deuxième assemblage arrière de la figure 9, et
- la figure 14 représente schématiquement, selon une vue dans un plan formé par les directions transversale et longitudinale, un exemple de module photovoltaïque obtenu par le biais d'un procédé de fabrication conforme à l'invention.

Dans l'ensemble de ces figures, des références identiques peuvent désigner des éléments identiques ou analogues.

De plus, les différentes parties représentées sur les figures ne le sont pas nécessairement selon une échelle uniforme, pour rendre les figures plus lisibles.

### DESCRIPTION DETAILLEE DE L'INVENTION

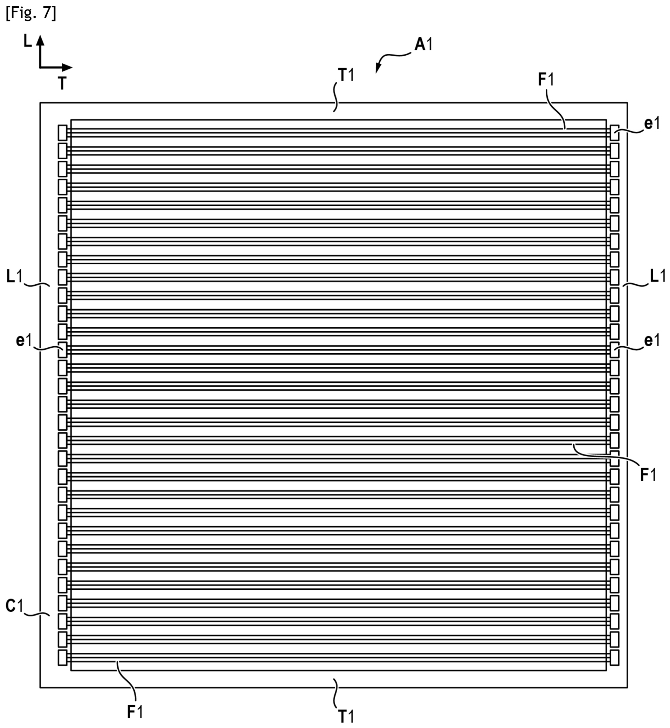

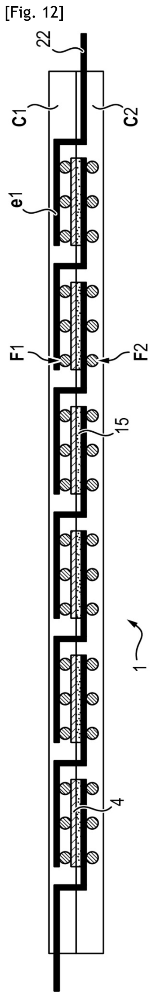

Les figures 1 à 6 ont déjà été décrites précédemment dans la partie relative à l'état de la technique antérieure et au contexte technique de l'invention. Les éléments communs aux figures 1 à 6 et aux figures 7 à 14 ne sont donc pas décrits de nouveau.

De plus, il est à noter qu'un module photovoltaïque 1 obtenu par le procédé de fabrication conforme à l'invention peut comporter des couches constitutives semblables à celles décrites en référence aux figures 1 et 2, lesquelles ne sont donc pas décrites de nouveau.

En référence aux figures 7 à 14, on va maintenant décrire les principes d'interconnexion de cellules photovoltaïques 4 et de fabrication d'un module photovoltaïque 1 conformes à l'invention.

Avantageusement, l'interconnexion des cellules photovoltaïques 4 utilise des fils métalliques F1, F2, décrits par la suite, et notamment des fils de cuivre, qui viennent au contact de doigts de collecte 8 présents sur les cellules photovoltaïques 4. De plus, les cellules photovoltaïques 4 sont choisies pour être dépourvues de busbar ou bus de collecte. Aussi, chaque cellule photovoltaïque 4 est choisie pour être de type BB0. La suppression des busbars sur les cellules photovoltaïques 4 peut permettre de s'affranchir des problèmes d'alignement, et également de réduire la consommation d'argent.

De plus, comme selon le procédé d'interconnexion dit « tuilage » ou « shingle » décrit précédemment, chaque cellule photovoltaïque 4 présente un format découpé, résultant d'un découpage en N parties, N étant un nombre entier supérieur ou égal à 2, du format d'une cellule photovoltaïque de référence, en particulier une cellule photovoltaïque de référence de type Mx ou Gx où x désigne un nombre entier supérieur ou égal à 0, notamment compris entre 0 et 12. Avantageusement, un tel découpage peut permettre de limiter le courant électrique. Ainsi, par exemple ici, chaque cellule photovoltaïque 4 peut correspondre à 1/6 d'une cellule photovoltaïque de référence (cellule pleine).

Avantageusement, l'invention permet de ne par avoir de contraintes sur les bords des cellules photovoltaïques 4 puisqu'il n'y a pas de superposition de cellules, ni de surépaisseurs dues aux rubans ou aux fils. L'invention permet de densifier le module photovoltaïque 1, comme dans les cas du « shingle » ou du « paving » décrits précédemment, mais sans perte de surface active. De plus, dans le cas de cellules de type HJT, il n'y a pas d'augmentation de la consommation d'argent par rapport à l'interconnexion classique.

L'invention permet également une augmentation de la cadence, pouvant atteindre près de 10000 cellules/heure, et une simplification du procédé d'interconnexion. Ainsi, toutes les étapes décrites par la suite peuvent être effectuées de manière automatisée, notamment avec équipement comprenant des robots de manipulation.

La figure 7 représente la formation d'un premier assemblage avant A1 destiné à former un module photovoltaïque 1.

Ce premier assemblage avant A1 comporte tout d'abord un premier cadre avant C1. Tout comme le deuxième cadre arrière C2 décrit par la suite, ce premier cadre avant C1 sert à la fois de support aux fils d'interconnexion mais également de protection et de rigidification du module photovoltaïque 1.

Le premier cadre avant C1 est défini par deux montants longitudinaux avant L1 espacés l'un de l'autre, parallèles à une direction longitudinale L, et deux montants transversaux avant T1 espacés l'un de l'autre, parallèles à une direction transversale T, perpendiculaire à la direction longitudinale L.

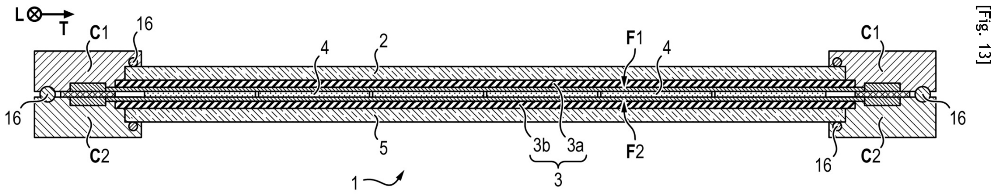

De plus, bien que non visible sur la figure 7 mais représenté sur la figure 13, le premier assemblage avant A1 comporte encore une première couche 2, ici du verre par exemple, s'étendant entre les montants longitudinaux avant L1 et les montants transversaux avant T1 du premier cadre avant C1.

En outre, le premier assemblage avant A1 comporte aussi une couche avant de matériau d'encapsulation 3a s'étendant au contact de la première couche 2, et destinée à former une partie de l'ensemble encapsulant 3 du module photovoltaïque 1.

La figure 7 représente également les premiers fils métalliques avant F1 qui s'étendent parallèlement entre eux et transversalement entre les deux montants transversaux avant T1 du premier cadre avant C1 au contact de la couche avant de matériau d'encapsulation 3a (voir figure 13).

Aux extrémités des premiers fils métalliques avant F1 se trouvent des premiers éléments de connectique e1 disposés sur les montants longitudinaux avant L1.

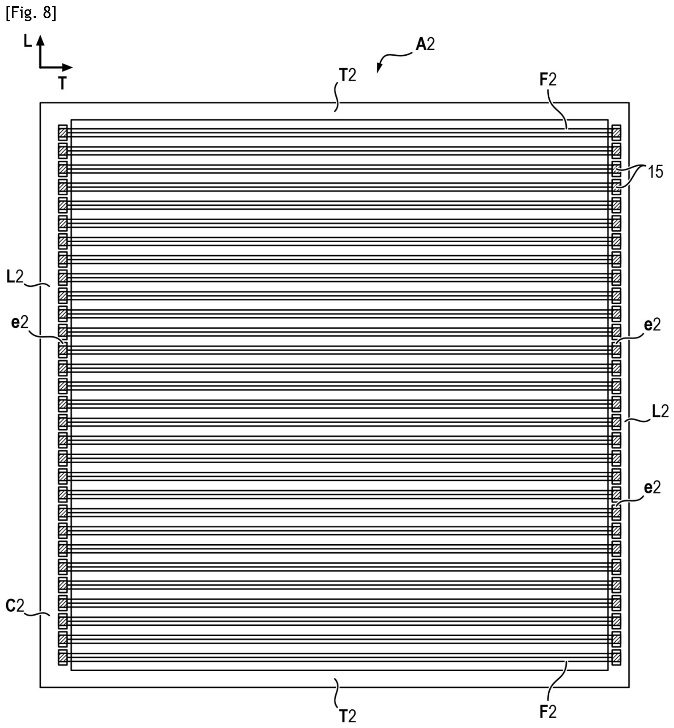

Par ailleurs, la figure 8 représente la formation du deuxième assemblage arrière A2 destiné à former le module photovoltaïque 1.

De façon similaire au premier assemblage avant A1, ce deuxième assemblage arrière A2 comporte un deuxième cadre arrière C2 défini par deux montants longitudinaux arrière L2 espacés l'un de l'autre, parallèles à la direction longitudinale L, et deux montants transversaux arrière T2 espacés l'un de l'autre, parallèles à la direction transversale T.

De plus, le deuxième assemblage arrière A2 comporte une deuxième couche 5, non représentée sur la figure 8 mais visible sur la figure 13, destinée à former la face arrière du module photovoltaïque 1, qui s'étend entre les montants longitudinaux arrière L2 et les montants transversaux arrière T2 du deuxième cadre arrière C2.

Le deuxième assemblage arrière A2 comporte également une couche arrière de matériau d'encapsulation 3b s'étendant au contact de la deuxième couche 5, ici par exemple en verre, destinée à former une partie de l'ensemble encapsulant 3.

Des deuxièmes fils métalliques F2 s'étendent parallèlement entre eux et transversalement entre les deux montants transversaux arrière T2 du deuxième cadre arrière C2 au contact de la couche arrière de matériau d'encapsulation 3b.

De plus, des deuxièmes éléments de connectique e2 sont disposés sur les montants longitudinaux arrière L2 et sont reliés aux extrémités des deuxièmes fils métalliques F2.

Afin d'éviter tout court-circuit entre les premiers fils métalliques avant F1 et les deuxièmes fils métalliques arrière F2 lors de la mise en contact des premier A1 et deuxième A2 assemblages, un matériau isolant 15 est positionné au contact des premiers éléments de connectique e1 et/ou au contact des deuxièmes éléments de connectique e2. Ici, comme visible sur la figure 8, plusieurs matériaux isolants 15 sont positionnés au contact des deuxièmes éléments de connectique e2. Il est à noter que le matériau isolant 15 peut être déjà intégré au préalable et que cette étape intermédiaire de dépose de matériau isolant peut être optionnelle dans ce cas.

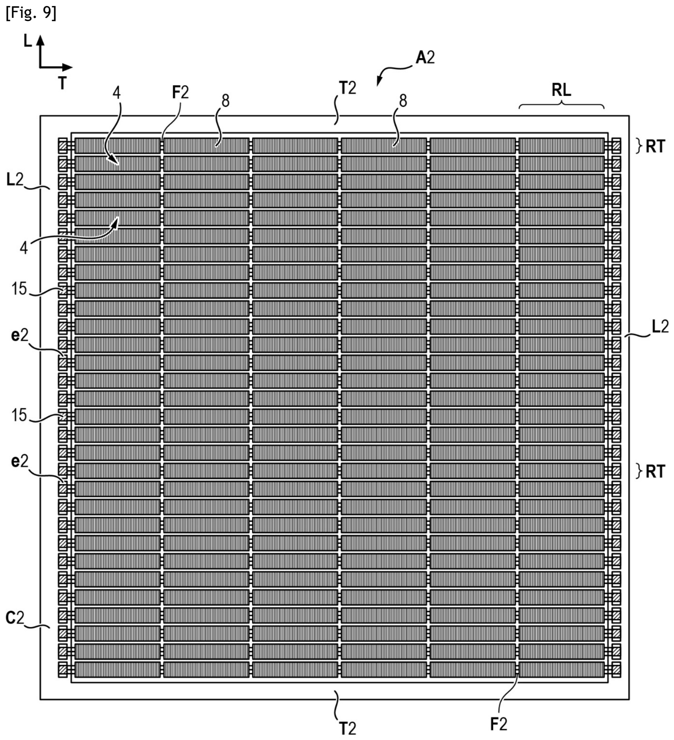

Par la suite, comme représenté sur la figure 9, les cellules photovoltaïques 4 sont placées au contact des deuxièmes fils métalliques F2 du deuxième assemblage arrière A2. Les cellules photovoltaïques 4 sont positionnées selon des rangées transversales RT, ici 6 cellules photovoltaïques 4 dans chaque rangée transversale RT. De plus, elles forment des rangées longitudinales RL, ici 6 rangées longitudinales RL. Il est à noter que, dans cet exemple, chaque cellule photovoltaïque 4 correspondant à 1/6 d'une cellule de référence, six rangées transversales RT sont équivalentes à une rangée transversale de 6 cellules de référence.

Lors du positionnement des cellules photovoltaïques 4, les doigts de collecte 8 sont orientés selon la direction longitudinale L tandis que les deuxièmes fils métalliques F2 sont orientés selon la direction transversale T.

De cette façon, on forme ainsi ici 30 rangées transversales RT de cellules photovoltaïques 4 interconnectées entre elles en série. De façon générale, il peut être possible de former jusqu'à une centaine de telles rangées transversales RT.

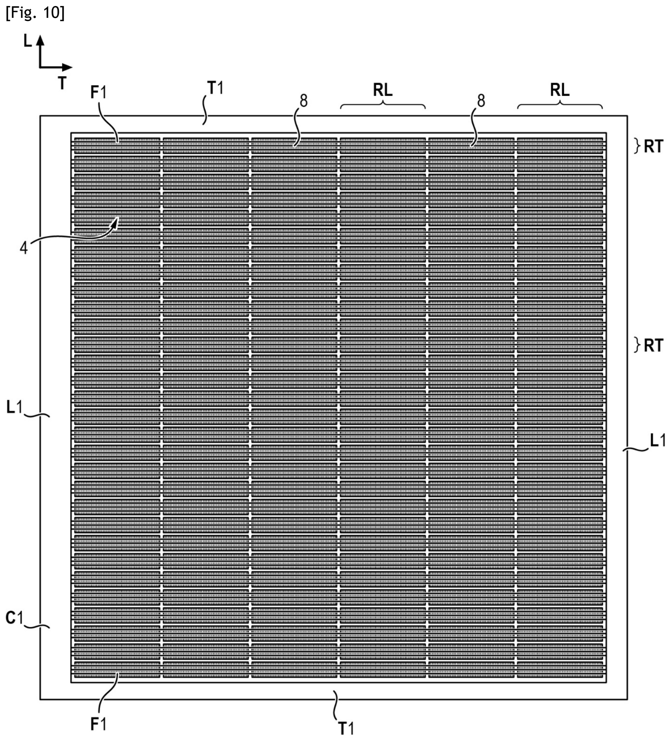

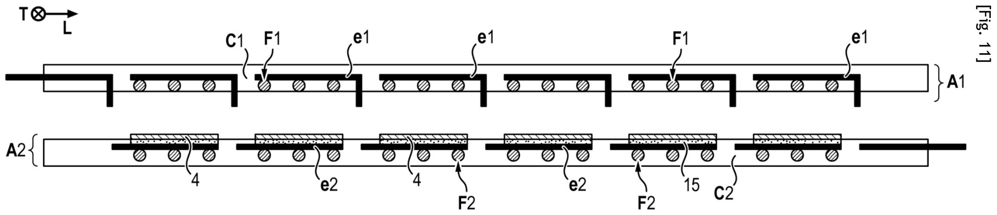

Par ailleurs, les figures 10 et 11 représentent l'étape de la mise en contact du premier assemblage avant A1 (figure 7) et du deuxième assemblage arrière A2 comprenant les cellules photovoltaïques 4 (figure 9) pour la mise en connexion électrique des premiers éléments de connectique e1 et des deuxièmes éléments de connectique e2 formant des rangées longitudinales RL de cellules photovoltaïques 4 interconnectées en parallèle. Cette connexion se fait de manière automatique lors de la mise en contact des deux cadres C1, C2. La figure 13 représente par ailleurs la structure obtenue après mise en contact des premier A1 et deuxième A2 assemblages.

Il est à noter que chaque cellule photovoltaïque peut par exemple présenter une largeur, mesurée selon la direction transversale T, comprise entre 156 mm et 210 mm. De plus, les cellules photovoltaïques 4 peuvent être en juxtaposition les unes des autres, sans recouvrement entre elles, avec un espacement entre deux cellules photovoltaïques 4 adjacentes compris entre 0 et 0,5 mm. La densité en W/m² du module photovoltaïque 1 peut être ainsi augmentée.

Lors de l'obtention du module photovoltaïque 1 par un tel procédé de fabrication et d'interconnexion, des joints de scellement 16 peuvent être présents sur le pourtour des couches 2 et 5, ici en verre, et des cadres C1, C2 afin d'assurer l'étanchéité, comme visible sur la figure 13.

Par ailleurs, il est à noter que l'interconnexion des cellules photovoltaïques 4 peut être suivie d'une étape de brasage. Celle-ci peut être réalisée directement après assemblage ou bien encore au cours d'une étape de lamination en fonction du type de revêtement métallique des fils F1, F2. L'étape de lamination peut être une étape de lamination à chaud, notamment à une température supérieure ou égale à 90°C, voire supérieure ou égale à 100°C, voire encore supérieure ou égale à 120°C, et notamment à une température inférieure ou égale à 180°C, voire encore inférieure ou égale à 170°C, préférentiellement comprise entre 150°C et 180°C, voire encore entre 160°C et 170°C, et pendant une durée du cycle de lamination d'au moins 10 minutes.

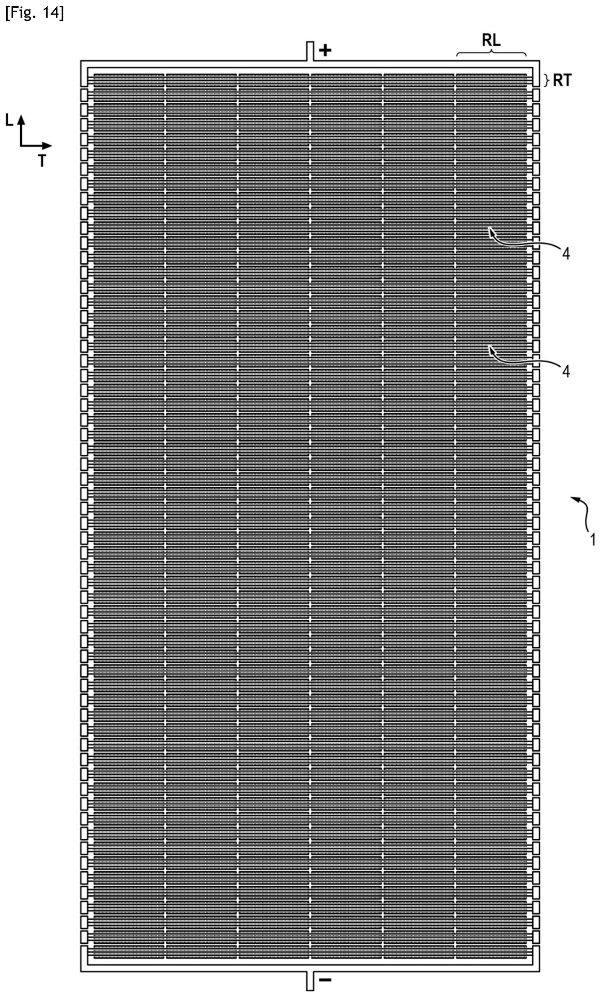

En outre, la figure 14 représente un exemple de module photovoltaïque 1 obtenu par le biais d'un procédé de fabrication conforme à l'invention. Ici, le module est un module « équivalent 60 cellules », soit la moitié d'un module dit papillon de 120 cellules, avec la mise en série de 60 rangées transversales RT de six cellules photovoltaïques 4 de type 1/6 de cellule de référence. Un tel module photovoltaïque 1 comporte alors 6 rangées longitudinales RL.

Bien entendu, l'invention n'est pas limitée aux exemples de réalisation qui viennent d'être décrits. Diverses modifications peuvent y être apportées par l'homme du métier.

## Revendications

1. Procédé d'interconnexion de cellules photovoltaïques (4), les cellules photovoltaïques (4) étant chacune recouvertes d'une grille métallisée comportant des doigts de collecte (8), **caractérisé en ce qu'**il comporte les étapes successives suivantes :
- l'étape de positionnement d'une pluralité de cellules photovoltaïques (4), selon des rangées transversales (RT) s'étendant selon une direction transversale (T), les doigts de collecte (8) étant orientés selon une direction longitudinale (L) perpendiculaire à la direction transversale (T), au contact de premiers fils métalliques (F1), orientés selon la direction longitudinale (L), d'un premier assemblage avant (A1), ou au contact de deuxièmes fils métalliques (F2), orientés selon la direction longitudinale (L), d'un deuxième assemblage arrière (A2), formant des rangées transversales (RT) de cellules photovoltaïques (4) interconnectées en série, les extrémités des premiers fils métalliques (F1) étant reliés à des premiers éléments de connectique (e1) et les extrémités des deuxièmes fils métalliques (F2) étant reliés à des deuxièmes éléments de connectique (e2),
- l'étape de mise en contact du premier assemblage avant (A1) et du deuxième assemblage arrière (A2) pour la mise en connexion électrique des premiers éléments de connectique (e1) et des deuxièmes éléments de connectique (e2) formant des rangées longitudinales (RL) de cellules photovoltaïques (4) interconnectées en parallèle.

2. Procédé d'interconnexion selon la revendication 1, dans lequel chaque cellule photovoltaïque (4) est dépourvue de piste conductrice de type busbar.

3. Procédé d'interconnexion selon la revendication 1 ou 2, dans lequel chaque cellule photovoltaïque (4) présente un format découpé, résultant d'un découpage en N parties, N étant un nombre entier supérieur ou égal à 2, notamment égal à 6, du format d'une cellule photovoltaïque de référence, notamment une cellule photovoltaïque de référence de type Mx ou Gx où x désigne un nombre entier supérieur ou égal à 0, notamment compris entre 0 et 12.

4. Procédé d'interconnexion selon l'une des revendications précédentes, dans lequel chaque cellule photovoltaïque (4) présente une largeur, mesurée selon la direction transversale (T), comprise entre 156 mm et 210 mm.

5. Procédé d'interconnexion selon l'une quelconque des revendications précédentes, dans lequel les premiers fils métalliques (F1) et/ou les deuxièmes fils métalliques (F2) sont des fils constitués d'un cœur en un unique métal, notamment du cuivre, et d'un revêtement en un alliage métallique, notamment de type SnPb, SnPbBi, SnAgBi ou SnAgCu.

6. Procédé d'interconnexion selon l'une quelconque des revendications précédentes, dans lequel l'étape de positionnement de la pluralité de cellules photovoltaïques (4) comporte le positionnement des cellules photovoltaïques (4) en juxtaposition les unes des autres, sans recouvrement entre elles, notamment avec un espacement entre deux cellules photovoltaïques (4) adjacentes compris entre 0 et 0,5 mm.

7. Procédé de fabrication d'un module photovoltaïque (1) comportant :
- une première couche (2) formant la face avant du module photovoltaïque (1),
- une pluralité de cellules photovoltaïques (4) disposées côte à côte et reliées électriquement entre elles,
- un ensemble encapsulant (3) la pluralité de cellules photovoltaïques (4), l'ensemble encapsulant (3) étant formé par une couche avant de matériau d'encapsulation (3a) et une couche arrière de matériau d'encapsulation (3b) disposées de part et d'autre des cellules photovoltaïques (4),
- une deuxième couche (5) formant la face arrière du module photovoltaïque (1), l'ensemble encapsulant (3) et la pluralité de cellules photovoltaïques (4) étant situés entre les première (2) et deuxième (5) couches, au moins l'une des première couche (2) et deuxième couche (5) étant transparente et destinée à recevoir un flux lumineux, **caractérisé en ce qu'**il comporte l'étape d'interconnexion des cellules photovoltaïques (4) par le biais d'un procédé d'interconnexion selon l'une quelconque des revendications précédentes.

8. Procédé de fabrication selon la revendication 7, comportant l'étape de formation d'un premier assemblage avant (A1), comportant :
- un premier cadre avant (C1) défini par deux montants longitudinaux avant (L1), parallèles à la direction longitudinale (L), et deux montants transversaux avant (T1), parallèles à la direction transversale (T), perpendiculaire à la direction longitudinale (L),
- la première couche (2) s'étendant entre les montants longitudinaux avant (L1) et les montants transversaux avant (T1) du premier cadre avant (C1),
- la couche avant de matériau d'encapsulation (3a) s'étendant au contact de la première couche (2),
- une pluralité de premiers fils métalliques avant (F1) s'étendant transversalement entre les deux montants transversaux avant (T1) du premier cadre avant (C1) au contact de la couche avant de matériau d'encapsulation (3a),
- une pluralité de premiers éléments de connectique (e1) disposés sur les montants longitudinaux avant (L1), les premiers fils métalliques (F1) étant reliés aux premiers éléments de connectique (e1).

9. Procédé de fabrication selon la revendication 7 ou 8, comportant l'étape de formation d'un deuxième assemblage arrière (A2), comportant :
- un deuxième cadre arrière (C2) défini par deux montants longitudinaux arrière (L2), parallèles à la direction longitudinale (L), et deux montants transversaux arrière (T2), parallèles à la direction transversale (T), perpendiculaire à la direction longitudinale (L),
- la deuxième couche (5) s'étendant entre les montants longitudinaux arrière (L2) et les montants transversaux arrière (T2) du deuxième cadre arrière (C2),
- la couche arrière de matériau d'encapsulation (3b) s'étendant au contact de la deuxième couche (5),
- une pluralité de deuxièmes fils métalliques arrière (F2) s'étendant transversalement entre les deux montants transversaux arrière (T2) du deuxième cadre arrière (C2) au contact de la couche arrière de matériau d'encapsulation (3b),
- une pluralité de deuxièmes éléments de connectique (e2) disposés sur les montants longitudinaux arrière (L2), les deuxièmes fils métalliques (F2) étant reliés aux deuxièmes éléments de connectique (e2).

10. Procédé de fabrication selon la revendication 8 ou 9, comportant l'étape de positionnement d'un matériau isolant (15) au contact des premiers éléments de connectique (e1) et/ou au contact des deuxièmes éléments de connectique (e2).

11. Procédé de fabrication selon les revendications 8 et 9, dans lequel l'étape d'interconnexion des cellules photovoltaïques (4) comporte la mise en contact du premier assemblage avant (A1) et du deuxième assemblage arrière (A2), laquelle est suivie par une étape d'étanchéification du pourtour du module photovoltaïque (1), notamment par le positionnement d'au moins un joint de scellement (16) sur le pourtour du module photovoltaïque (1), notamment entre les premier cadre avant (C1) et deuxième cadre arrière (C2), entre le premier cadre avant (C1) et la première couche (2) et/ou entre le premier cadre arrière (C2) et la deuxième couche (5).

12. Procédé de fabrication selon l'une quelconque des revendications 7 à 11, dans lequel l'étape d'interconnexion des cellules photovoltaïques (4) est suivie d'une étape de brasage.

13. Procédé de fabrication selon l'une quelconque des revendications 7 à 12, comportant une étape de lamination à chaud à une température supérieure ou égale à 90°C, notamment supérieure ou égale à 100°C, notamment encore supérieure ou égale à 120°C, notamment encore inférieure à 180°C, notamment encore inférieure à 170°C, notamment comprise entre 150°C et 180°C, notamment encore comprise entre 160°C et 170°C, et pendant une durée du cycle de lamination d'au moins 10 minutes, des couches constitutives du module photovoltaïque (1).

14. Procédé de fabrication selon les revendications 12 et 13, dans lequel l'étape de brasage est réalisée au cours de l'étape de lamination à chaud.

15. Procédé selon l'une quelconque des revendications précédentes, dans lequel les étapes sont réalisées de manière automatisée, notamment par le biais de robots de manipulation.
